# EUROPEAN PATENT APPLICATION

(11) **EP 4 682 883 A1**
(43) Date of publication of application: **21.01.2026**
(21) Application number: 25177279.4
(22) Date of filing: 19.05.2025
(51) Int. Cl.: G11C 11/4074, G11C 11/4097, H10B 12/00

(54) **MEMORY DEVICE**

(30) Priority: 15.07.2024 KR 20240092907
(71) Applicant: Samsung Electronics Co., Ltd., Suwon-si, Gyeonggi-do 16677 (KR)
(72) Inventor: KIM, Yoonjae, 16677 Suwon-si (KR); HAN, Jinwoo, 16677 Suwon-si (KR)
(74) Representative: Marks & Clerk LLP

(57) **Abstract**

A memory device includes: local bit line structures arranged in first and second directions parallel to a surface of a substrate and intersecting each other, and extending across a plurality of vertical levels; first and second channel structures extending in the first direction on each of the plurality of levels and respectively contacting sidewalls of each of the local bit line structures and having first and second impurity regions; gate structures extending in the second direction on each of the plurality of levels, and respectively contacting the channel structures arranged in the second direction; cell capacitors in contact with the second impurity regions; first interconnection patterns respectively electrically connected to the second impurity regions on one or more first levels of the plurality of levels; and second interconnection patterns respectively electrically connected to the second impurity regions on the one or more first levels.

## Description

### BACKGROUND

The present disclosure relates generally to a memory device, and more particularly relates to a memory device having reduced loading capacitance on a signal line.

A memory device may include a plurality of memory cells to store data bits. A memory device is required to store a large amount of data while having a small area. Recently, a memory device in which memory cells are arranged in three dimensions have been actively researched in order to improve the integration of the memory device.

As the memory cells are integrated at a high density in the memory device, the number of memory cells connected to a single signal line may increase, and the load on the signal line may increase.

### SUMMARY

An aspect of the present disclosure is to provide a memory device that may reduce the loading capacitance of a signal line and simplify the manufacturing process.

A memory device according to an example embodiment of the present disclosure includes: a substrate; a plurality of local bit line structures arranged in a first direction and a second direction parallel to an upper surface of the substrate and intersecting each other, and extending across a plurality of levels defined in a vertical direction, perpendicular to the upper surface of the substrate; a plurality of first channel structures and a plurality of second channel structures extending in the first direction on each of the plurality of levels, and respectively contacting (e.g. directly contacting) sidewalls of each of the plurality of local bit line structures and having first impurity regions facing each other and second impurity regions opposite the first impurity regions; a plurality of gate structures extending in the second direction on each of the plurality of levels, and respectively contacting (e.g. directly contacting) the channel structures arranged in the second direction, among the plurality of first channel structures and the plurality of second channel structures; a plurality of cell capacitors in contact (e.g. in direct contact) with the second impurity regions of each of the plurality of first channel structures and the plurality of second channel structures; a plurality of first interconnection patterns extending in the first direction and arranged in the second direction, and respectively electrically connected to the second impurity regions of the first channel structures arranged in the first direction, among the plurality of first channel structures on one or more first levels of the plurality of levels; and a plurality of second interconnection patterns extending in the second direction and arranged in the first direction, and respectively electrically connected to the second impurity regions of the second channel structures arranged in the second direction, among the plurality of second channel structures on the one or more first levels.

According to an embodiment, the memory device includes a plurality of first channel structure and a plurality of second channel structures, wherein each channel structure includes a first impurity region and a second impurity region. Each local bit line structure contacts a first channel structure and a second channel structure on each level. For instance, adjacent first and second channel structures contact a corresponding local bit line. First impurity regions of adjacent channel structures of the plurality of first and second channel structures face one another and contact respective sidewalls of a respective local bit line structure.

A memory device according to an example embodiment of the present disclosure includes: a substrate; a plurality of local bit line structures arranged in a first direction and a second direction parallel to an upper surface of the substrate and intersecting each other, and respectively extending in a vertical direction across a plurality of first levels and one or more second levels defined in the vertical direction, perpendicular to the upper surface of the substrate; a plurality of first channel structures and a plurality of second channel structures extending in the first direction on each of the plurality of first levels and the one or more second levels, each of which is adjacent to sidewalls of each of the plurality of local bit line structures and has first impurity regions facing each other and second impurity regions opposite the first impurity regions; a plurality of gate structures extending in the second direction on each of the plurality of first levels and the one or more second levels, each of which is in contact with channel structures arranged in the second direction, among the plurality of first channel structures and the plurality of second channel structures; a plurality of cell capacitors adjacent to the second impurity regions of each of the plurality of first channel structures and the plurality of second channel structures on each of the plurality of first levels; a plurality of first interconnection patterns extending in the first direction and arranged in the second direction, and electrically connected to second impurity regions of channel structures arranged in the first direction, among the plurality of first channel structures on the one or more second levels; and a plurality of second interconnection patterns extending in the second direction and arranged in the first direction, and electrically connected to second impurity regions of channel structures arranged in the second direction, among the plurality of second channel structures on the one or more second levels.

A memory device according to an example embodiment of the present disclosure includes: a first semiconductor layer; and a second semiconductor layer stacked on the first semiconductor layer, and the first semiconductor layer includes: a memory cell structure including a plurality of local bit line structures disposed in a first direction parallel to a substrate and a second direction parallel to the substrate and intersecting the first direction and extending in a vertical direction, perpendicular to the substrate, first cell transistors and second cell transistors respectively including a first impurity region in a plurality of positions in the vertical direction and connected to each of the plurality of local bit line structures and a second impurity region, and a plurality of cell capacitors connected to second impurity regions of cell transistors in a plurality of first positions among the plurality of positions, among the first cell transistors and the second cell transistors; and a plurality of first interconnection patterns electrically connected to second impurity regions of the first cell transistors disposed in one or more second positions, among the plurality of positions; and a plurality of second interconnection patterns electrically connected to second impurity regions of the second cell transistors in the one or more second positions, and the second semiconductor layer includes: a plurality of bit line sense amplifiers electrically connected to each of the plurality of first interconnection patterns; and a precharge power source electrically connected to each of the plurality of second interconnection patterns.

A memory device according to an example embodiment of the present disclosure may reduce the loading capacitance of a global bit line using select transistors that selectively connect one of a plurality of local bit lines to a global bit line to which a bit line sense amplifier is connected.

A memory device according to an example embodiment of the present disclosure may simplify a semiconductor process for forming the cell transistors by utilizing cell transistors of some layers among three-dimensionally stack cell transistors as the select transistors.

The aspects to be solved by the present disclosure are not limited to the above-mentioned aspects, and other aspects not mentioned herein will be clearly understood by those skilled in the art from the following description.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:
FIG. 1 is a perspective view illustrating a structure of a cell transistor included in a memory device;
FIG. 2 is a perspective view illustrating a structure of a memory device according to an example embodiment of the present disclosure;
FIG. 3 is a perspective view illustrating an example structure of a memory cell structure;
FIG. 4 is a schematic circuit diagram of a memory device according to an example embodiment of the present disclosure;
FIG. 5 is a perspective view illustrating a structure of a memory device according to an example embodiment of the present disclosure;
FIG. 6 is a schematic cross-sectional view of the memory device illustrated with reference to FIG. 5 in an X-Z plane;
FIG. 7 is a schematic circuit diagram of region 'A' of FIG. 6;
FIGS. 8A, 8B, and 9 are enlarged schematic cross-sectional views of region 'A' of FIG. 6 according to example embodiments of the present disclosure;
FIG. 10 is a schematic cross-sectional view illustrating a structure of a memory device according to an example embodiment of the present disclosure;
FIG. 11 is a schematic circuit diagram of region 'B' of FIG. 10;
FIG. 12 is a schematic cross-sectional view taken along line I-I' of FIG. 10;
FIGS. 13 to 15 are schematic views illustrating intermediate processes in an example method of manufacturing the memory device of FIG. 10, according to one or more embodiments of the present disclosure; and
FIG. 16 is a schematic block diagram illustrating a memory device according to an example embodiment of the present disclosure.

### DETAILED DESCRIPTION

Hereinafter, example embodiments of the present disclosure will be described with reference to the accompanying drawings.

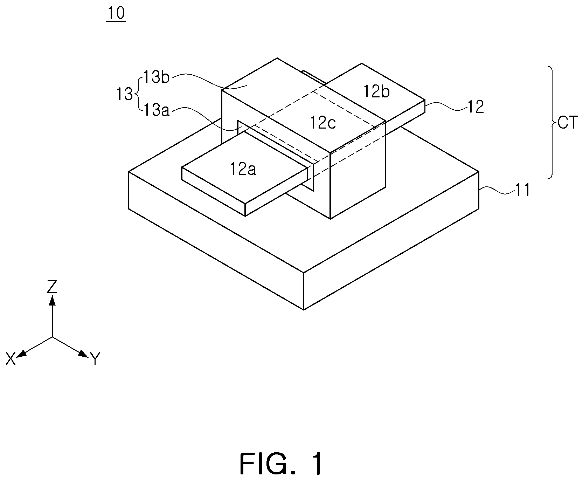

FIG. 1 is a perspective schematic view illustrating a structure of a cell transistor included in a memory device. The memory device may be a Dynamic Random Access Memory (DRAM).

A memory device may include a plurality of memory cells. Memory cells of a memory device such as a Dynamic Random Access Memory (DRAM) may include a cell capacitor and a cell transistor. The cell capacitor may store a data bit by accumulating a charge therein which is representative of a logical state (e.g., logic "1" or logic "0") of the memory cell, and the cell transistor may connect the cell capacitor to a bit line in response to a control signal transmitted through a word line.

FIG. 1 illustrates a semiconductor device 10 including a cell transistor CT. The cell transistor CT may include a channel structure 12 and a gate structure 13 formed on a substrate 11. The channel structure 12 may include a first impurity region 12a, a second impurity region 12b, and a channel region 12c. For example, the first impurity region 12a and the second impurity region 12b may be doped with impurities of a first impurity type (e.g. N-type), and the channel region 12c may be doped with impurities of a second impurity type (e.g. P-type). For example, the first impurity region 12a and the second impurity region 12b may be doped with N-type impurities, and the channel region 12c may be doped with P-type impurities. The gate structure 13 may include a gate insulating layer 13a and a gate electrode 13b.

The first impurity region 12a and the second impurity region 12b may provide a source and a drain of the cell transistor CT. For example, the first impurity region 12a may be connected to a bit line, and the second impurity region 12b may be connected to a cell capacitor. The term "connected" (or "connecting," or like terms, such as "contact" or "contacting"), as may be used herein, is intended to refer to a physical and/or electrical connection between two or more elements, and may include other intervening elements. As used herein, the term "and/or" includes any and all combinations of one or more of the associated listed items. The gate electrode 13b may provide a word line. For example, when a voltage higher than a threshold voltage of the cell transistor CT is applied to the gate electrode 13b, a channel may be formed in the channel region 12c, and as a result, the bit line and the cell capacitor may be electrically connected to each other.

In order to improve the characteristics of the memory cell while increasing the integration of the memory cell, the cell transistor CT may have the channel structure 12 surrounded by the gate structure 13. The term "surrounded" (or "surrounding," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. For example, the cell transistor may have a Gate All Around (GAA) structure. The channel structure 12 of the cell transistor CT may be separated from the substrate 11. Accordingly, a plurality of cell transistors may be vertically stacked (in a Z direction, perpendicular to a surface of the substrate 11) on the substrate 11. The term "vertical" may refer to a direction perpendicular to a surface (e.g. an upper surface of the substrate 11). Similarly, the term "horizontal" may refer to a direction parallel to the surface (e.g. the upper surface) of the substrate 11. It will be appreciated that these terms (and relative positions, such as "above" and "below") are relative to the structure of the device, and need not imply any particular orientation of the device in use.

In order to improve the integration of the memory device, the memory cells including cell transistors CT may be arranged three-dimensionally. In order to further reduce an area of the memory device, a Periphery on Cell (PoC) structure has been proposed in which a circuit for controlling the memory cell structure is disposed in an upper portion of the memory cell structure having the memory cells arranged three-dimensionally.

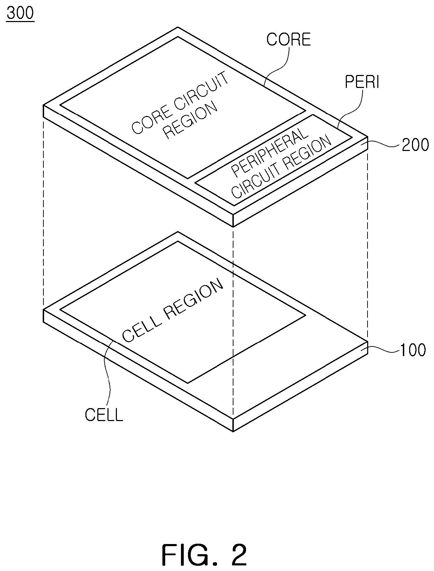

FIG. 2 is a schematic perspective view illustrating a structure of a memory device according to an example embodiment of the present disclosure.

Referring to FIG. 2, a memory device 300 may include a first semiconductor layer 100 and a second semiconductor layer 200. The first semiconductor layer 100 may include a cell region CELL in which one or more memory cell structures are disposed. The second semiconductor layer 200 may include a core circuit region CORE including, for example, a core control circuit for controlling the memory cell structure, and a peripheral circuit region PERI including a peripheral circuit. For example, the core control circuit may include a sub-word line driver for controlling word lines connected to the memory cells, and a bit line sense amplifier for sensing and amplifying signals of bit lines connected to the memory cells.

The core circuit region CORE may overlap the cell region CELL in a direction perpendicular to an upper surface of the substrate. As used herein, "an element A overlapping an element B in a direction X" (or similar language) means that there is at least one line that extends in the direction X and intersects both the elements A and B. As the integration of the memory cell is improved, an area of the cell region may be reduced. When an area of the core circuit region CORE may be reduced along with the area of the cell region CELL, an area of the memory device 300 may be effectively reduced.

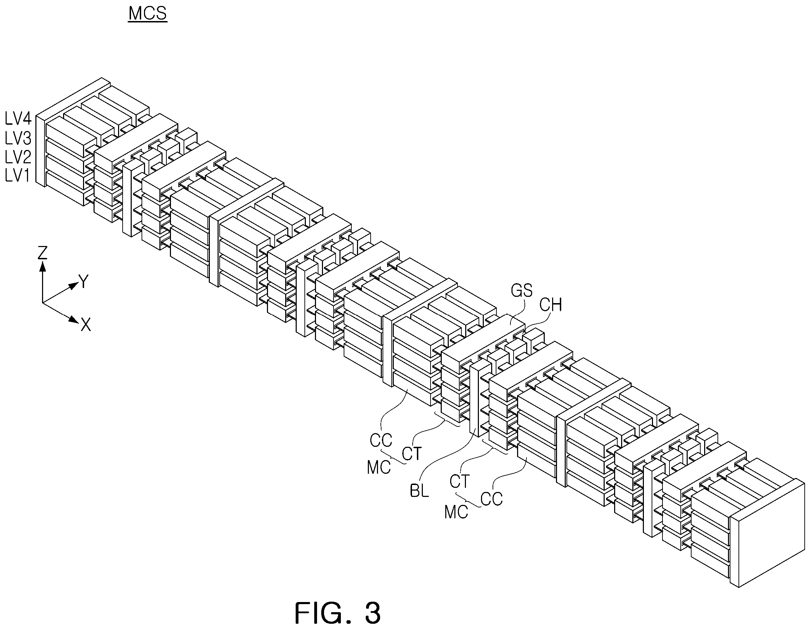

FIG. 3 is a view illustrating an example structure of a memory cell structure.

A first direction (X-direction) and a second direction (Y-direction) may be directions parallel to an upper (or lower) surface of the substrate (e.g., substrate 11 in FIG. 1) and may be directions intersecting each other. A third direction (Z-direction) may be a direction perpendicular to the upper (or lower) surface of the substrate. Although the substrate is omitted in FIG. 3, a memory cell structure MCS may be formed on the upper surface of the substrate.

The memory cell structure MCS may include a plurality of bit line structures BL arranged in the first direction (X-direction) and the second direction (Y-direction) and extending in the third direction (Z-direction), and a plurality of memory cells MC connected to the bit line structures BL.

The plurality of memory cells MC may be arranged in the first direction (X-direction), the second direction (Y-direction), and the third direction (Z-direction). Specifically, the plurality of memory cells MC may be arranged on each of a plurality of levels LV1 to LV4 in the third direction (Z-direction).

A plurality of memory cells MC may be in contact (e.g. in direct contact) with sidewalls of each of the bit line structures BL. For example, on each of the multiple levels LV1 to LV4, a pair of memory cells MC may be disposed on sidewalls of one bit line structure BL in a direction in which the pair of memory cells MC face each other. For instance, the pair of memory cells MC may be disposed on opposite sides of the bit line structure in the first direction (X-direction). One bit line structure BL may be shared by multiple pairs of memory cells MC (across the multiple levels LV1 to LV4).

Each of the memory cells MC may include a cell capacitor CC and a cell transistor CT. The cell capacitor CC may store positive charges corresponding to a data bit. The cell transistor CT may electrically connect the cell capacitor CC to the bit line structure BL.

The cell transistor CT may include a gate structure GS and a channel structure CH. A structure of the cell transistor CT may correspond to the structure of the illustrative cell transistor CT described with reference to FIG. 1.

The channel structure CH may extend in the first direction (X-direction) and may include a first impurity region connected to (e.g. directly connected to) the bit line structure BL, a second impurity region connected to (e.g. directly connected to) the cell capacitor CC, and a channel region between the first impurity region and the second impurity region.

The gate structure GS may extend in the second direction (Y-direction) and may be shared by a plurality of cell transistors CT arranged in the second direction (Y-direction) (e.g. on the same level of the plurality of levels LV1 to LV4). The gate structure GS may surround (i.e., extend around) the channel regions of the channel structures CH of the plurality of cell transistors CT in the second direction (Y-direction) and the third direction (Z-direction). However, the present disclosure is not limited thereto, and the gate structure GS may have a structure in which at least one surface thereof is in contact with the channel structures CH (e.g. one or more surfaces of the gate structure GS may not be in contact with the channel structures CH).

The gate structure GS may include gate insulating layers in contact with the channel structures CH, and a gate electrode in contact with the gate insulating layers and extending in the second direction (Y-direction). The gate electrode may provide a word line. That is, when a voltage higher than a threshold voltage of the cell transistor CT is applied to the gate electrode, a plurality of cell transistors CT connected to the gate electrode may be turned on, thereby electrically connecting the cell capacitors CC and the bit line structure BL to each other.

The bit line structures BL may extend in the third direction (Z-direction) and may be concentrated in the first direction (X-direction) and the second direction (Y-direction). Accordingly, an area in which core control circuits such as bit line sense amplifiers corresponding to each of a plurality of bit line structures BL may be disposed in an upper portion of the memory cell structure MCS may be reduced. In order to arrange the bit line sense amplifiers in a limited area, a structure has been proposed in which the plurality of bit line structures BL are connected to a global bit line, and one bit line sense amplifier is connected to the global bit line. In order to distinguish the bit line structure BL from the global bit line, the bit line structure BL may be referred to as a local bit line structure.

A structure in which bit lines are hierarchized into the global bit lines and the local bit lines may reduce the number of bit line sense amplifiers required by the memory device. Accordingly, the bit line sense amplifiers may be effectively disposed in a limited area. However, when the number of local bit lines connected to one bit line sense amplifier increases, loading capacitance of the bit line sense amplifier may increase. The increase in the loading capacitance may make it difficult for the bit line sense amplifier to sense a voltage level of the bit line in a set sensing margin.

Accordingly, a circuit has been proposed in which multiplexer circuits are connected between the global bit line and the local bit lines, and the multiplexer circuits connect one local bit line selected from the local bit lines to the global bit line.

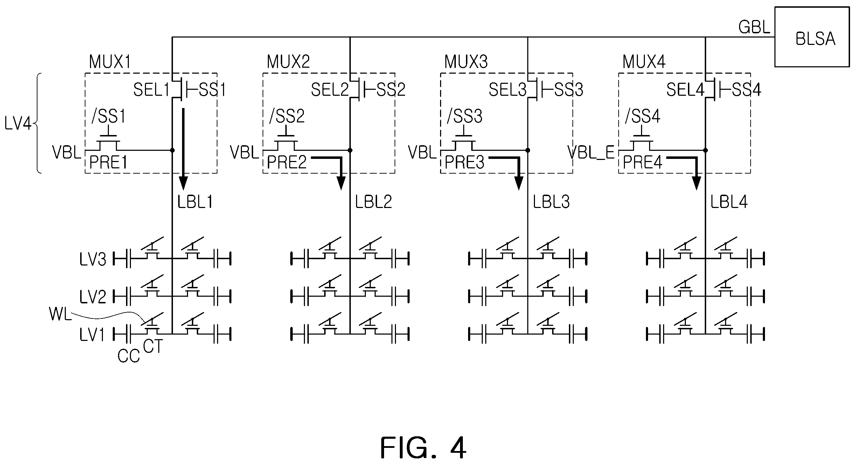

FIG. 4 is a circuit diagram of a memory device according to an example embodiment of the present disclosure.

FIG. 4 illustrates circuits associated with one global bit line GBL. Referring to FIG. 4, the global bit line GBL may correspond to a plurality of local bit lines LBL (LBL1 to LBL4). Each of the plurality of local bit lines LBL (LBL1 to LBL4) may be selectively connected to the global bit line GBL or to a precharge line VBL through multiplexer circuits MUX (MUXI1 to MUX4, respectively).

Each of the plurality of local bit lines LBL may be connected to a plurality of memory cells, each of which includes a cell capacitor CC and a cell transistor CT. The global bit line GBL may be connected to a bit line sense amplifier BLSA. Although omitted in FIG. 4, the bit line sense amplifier BLSA may be further connected to a complementary global bit line that is paired with the global bit line GBL. The bit line sense amplifier BLSA may compare a voltage level of the global bit line with a voltage level of the complementary global bit line so as to sense the voltage level of the global bit line.

A first multiplexer circuit MUX1 may include a first select transistor SEL1 and a first precharge transistor PRE1. The first select transistor SEL1 may connect a first local bit line LBL1 to the global bit line GBL in response to a logic state of a first select signal SS1. When an n-channel metal-oxide-semiconductor (NMOS) transistor is used as the select transistor SEL1, a logic high state of the first select signal SS1 will turn on the first select transistor SEL1 thereby connecting the first local bit line LBL1 to the global bit line GBL; when a p-channel metal-oxide-semiconductor (PMOS) transistor is used as the select transistor SEL1, a logic low state of the first select signal SS1 will turn on the first select transistor SEL1. Additionally, the first precharge transistor PRE1 may connect the first local bit line LBL1 to the precharge line VBL in response to a logic high state of a first inverted select signal /SS1, which is an inverted signal of the first select signal SS1. The precharge transistor PRE1 may allow the bit line (e.g. the first local bit line LBL1) to be precharged. Precharging may be a process of setting a bit line to a predefined voltage (e.g. half of the supply voltage).

Second to fourth multiplexer circuits MUX2 to MUX4 may also include select transistors SEL2 to SEL4 and precharge transistors PRE2 to PRE4, similarly to the first multiplexer circuit MUX1.

The multiplexer circuits MUX1 to MUX4 may select a local bit line electrically connected to the global bit line GBL, among the plurality of local bit lines LBL1 to LBL4.

For example, in order to access the memory cell MC connected to the first local bit line LBL1, the first local bit line LBL1 may be connected to the global bit line GBL, and the second to fourth local bit lines LBL2 to LBL4 may be disconnected from the global bit line GBL.

Assuming NMOS transistors are used for the select and precharge transistors in the multiplexer circuits MUX1 to MUX4, the first select signal SS1 may be in a logic high state so that the first local bit line LBL1 may be connected to the global bit line GBL, and the second to fourth select signals SS2 to SS4 may be in a logic low state so that the second to fourth local bit lines LBL2 to LBL4 may be disconnected from the global bit line GBL.

While the second to fourth local bit lines LBL2 to LBL4 are disconnected from the global bit line GBL, the second to fourth local bit lines LBL2 to LBL4 may be connected to the precharge line VBL in response to second to fourth inverted select signals /SS2 to /SS4 being in a logic high state. That is, while the first local bit line LBL1 is connected to the global bit line GBL, the second to fourth local bit lines LBL2 to LBL4 may be precharged. In an example embodiment, a voltage level of the precharge line VBL may be an intermediate level between a first power level VINTA, which is a power voltage level, and a second power level VSS, which is a ground voltage level.

It may be difficult to form precharge transistors and select transistors corresponding to each of the local bit lines LBL on an upper portion of the memory cell structure. For example, the precharge transistors and the select transistors may be formed on the same layer (e.g., level LV4) as that of the bit line sense amplifier BLSA, which may increase an area occupied by the core circuit region in the memory device. On the other hand, when an additional transistor layer is to be formed on the upper portion of the memory cell structure in order to vertically arrange the precharge transistors and the select transistors with respect to the bit line sense amplifier BLSA, a complex number of semiconductor processes may be required.

According to an example embodiment of the present disclosure, the memory device may use cell transistors disposed on some levels, among the cell transistors disposed on a plurality of levels of the memory cell structure, as the precharge transistors and the select transistors. For example, when the memory cell structure includes cell transistors disposed in four levels LV1 to LV4, the memory device may use cell transistors arranged in a fourth level LV4, which is a highest level, as the precharge transistors and the select transistors, and may use cell transistors disposed in the remaining three levels LV1 to LV3 as general cell transistors.

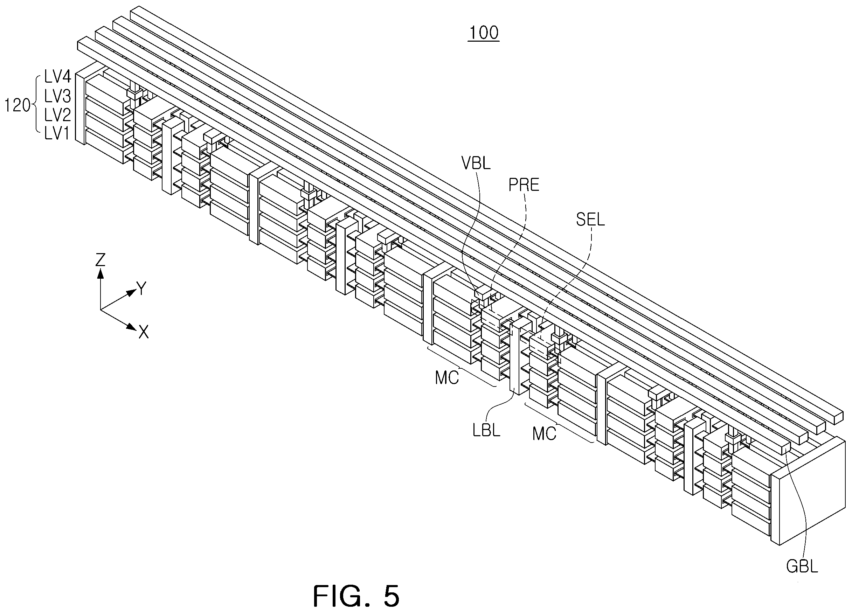

FIG. 5 is a perspective view illustrating a structure of a memory device according to an example embodiment of the present disclosure.

FIG. 5 illustrates an example structure of the first semiconductor layer 100 described with reference to FIG. 2. The first semiconductor layer 100 illustrates the memory cell structure MCS, the global bit lines GBL, and the precharge lines VBL.

The memory cell structure MCS of FIG. 5 may have the same structure as the memory cell structure MCS described with reference to FIG. 3. However, a memory cell structure 120 of FIG. 5 may include memory cells MC disposed in the first to third levels LV1 to LV3, and select transistors SEL and precharge transistors PRE disposed in the fourth level LV4.

The precharge lines VBL may extend from an upper portion of the memory cell structure MCS in the second direction (Y-direction) and may be arranged in the first direction (X-direction). The precharge lines VBL may extend over an upper portion of the memory cell structure MCS in the second direction (Y-direction) and may be arranged in the first direction (X-direction). Additionally, the global bit lines GBL may extend from the upper portion of the memory cell structure MCS in the first direction (X-direction) and may be arranged (i.e., spaced apart from one another) in the second direction (Y-direction). The global bit lines GBL may extend over the upper portion of the memory cell structure MCS in the first direction (X-direction) and may be arranged (i.e., spaced apart from one another) in the second direction (Y-direction). FIG. 5 illustrates a case in which the global bit lines GBL are disposed on the upper portion of the precharge lines VBL, but the present disclosure is not limited thereto. For example, the precharge lines VBL may be disposed on the upper portion of the global bit lines GBL.

One local bit line LBL may be connected to a pair of adjacent transistors in the fourth level LV4. In the fourth level LV4, the pair of transistors may be connected to one local bit line LBL in a direction in which the transistors face each other (e.g. in the first direction (X-direction)).

The pair of transistors may include one select transistor SEL and one precharge transistor PRE. The select transistor SEL may electrically connect the global bit line GBL and the local bit line LBL. The precharge transistor PRE may electrically connect the precharge line VBL and the local bit line LBL.

According to an example embodiment of the present disclosure, in a semiconductor process of forming a memory cell structure, precharge transistors and select transistors disposed vertically with respect to the cell transistors may be formed together. Accordingly, the number of semiconductor processes required to form the precharge transistors and the select transistors may be reduced without increasing an area occupied by the precharge transistors and the select transistors in the memory device. Accordingly, the productivity of the memory device may be improved while reducing the area of the memory device.

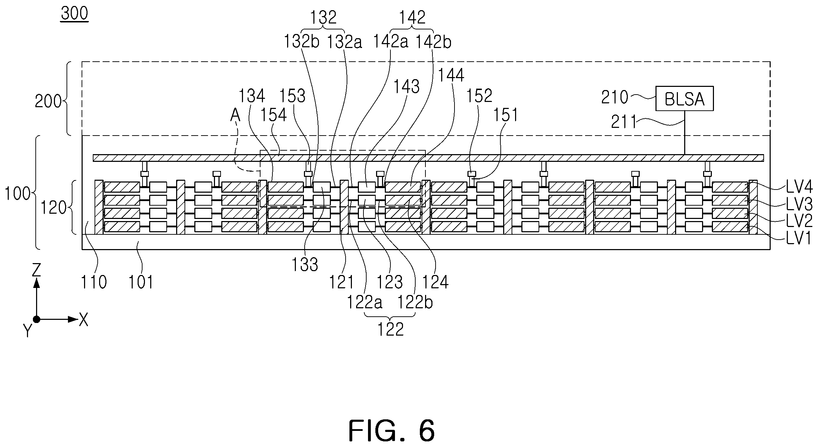

Hereinafter, the structure of the memory device according to an example embodiment of the present disclosure will be described in more detail with reference to FIGS. 6 to 9.

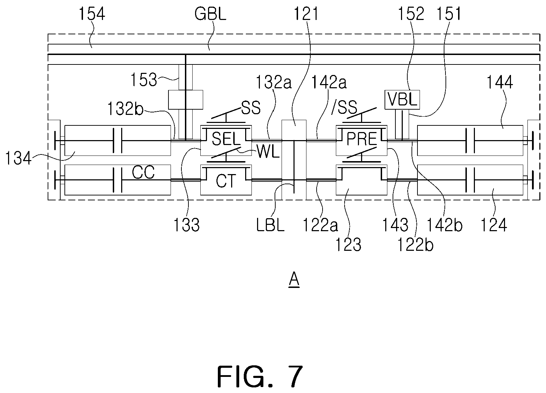

FIG. 6 is a cross-sectional view illustrating the memory device described with reference to FIG. 5 in an X-Z plane. FIG. 7 is a circuit diagram of region 'A' of FIG. 6.

Referring to FIGS. 6 and 7 together, the memory device 300 may include the first semiconductor layer 100 and the second semiconductor layer 200 as described with reference to FIG. 2. The second semiconductor layer 200 may be stacked on an upper portion of the first semiconductor layer 100 in the third direction (Z-direction).

The first semiconductor layer 100 may include a substrate 101, an insulating layer 110 disposed on the substrate 101, a memory cell structure 120 in the insulating layer 110, and conductive patterns 151, 152, 153 and 154 in the insulating layer 110. The memory cell structure 120 may include a plurality of local bit line (LBL) structures 121, a plurality of cell transistors CT, a plurality of cell capacitors 124, a plurality of select transistors SEL, a plurality of precharge transistors PRE, and dummy cell capacitors 134 and 144.

The second semiconductor layer 200 may include a core control circuit and a peripheral circuit. For example, the second semiconductor layer 200 may include a bit line sense amplifier (BLSA) 210 overlapping the memory cell structure 120 of the first semiconductor layer 100 in a third direction (Z-direction) perpendicular to an upper surface of the substrate 101, and a conductive pattern 211 for electrically connecting the bit line sense amplifier 210 to the conductive pattern 154 of the first semiconductor layer 100. The second semiconductor layer 200 may further include a precharge power supply.

The memory cell structure 120 may be disposed in the insulating layer 110, on an upper portion of the substrate 101. The memory cell structure 120 may be disposed across a plurality of levels LV1 to LV4 in the third direction (Z-direction). The memory cell structure 120 may move away from the substrate 101 in the order of the first level LV1 to the fourth level LV4, with the first level LV1 being the lowermost one of the plurality of levels LV1 to LV4 closest to the substrate 101.

The local bit line structures 121 may extend in the third direction Z across the plurality of levels LV1 to LV4. At least a subset of the plurality of cell transistors CT and at least a subset of the plurality of cell capacitors 124 may be disposed in each of the first to third levels LV1 to LV3.

The plurality of cell transistors CT may include a channel structure 122 and a gate structure 123. A first impurity region 122a and a second impurity region 122b of the channel structure 122 may be exposed to the outside of the gate structure 123, and the channel region may be disposed in the gate structure 123. The term "exposed" (or "expose," or like terms) may be used herein to describe relationships between elements and/or with reference to intermediate processes in fabricating a semiconductor device, but may not require exposure of a particular element in the completed device. Likewise, the term "not exposed" may be used to described relationships between elements and/or with reference to intermediate processes in fabricating a semiconductor device, but may not require a particular element to be unexposed in the completed device. The first impurity region 122a may be in contact with the local bit line structure 121, and the second impurity region 122b may be in contact with the cell capacitor 124. In each of the first to third levels LV1 to LV3, a pair of cell transistors CT may be disposed to face each other in one local bit line structure 121. The pair of cell transistors CT may be referred to as a first cell transistor and a second cell transistor.

According to an example embodiment of the present disclosure, the select transistors SEL and the precharge transistors PRE may be disposed on the fourth level LV4. The fourth level LV4 may be a highest level among the plurality of levels LV1 to LV4 and may be a level furthest from the substrate 101.

The select transistors SEL may include a channel structure 132 and a gate structure 133. Similarly to the cell transistors CT, the select transistors SEL may have a first impurity region 132a and a second impurity region 132b exposed to the outside of the gate structure 133, and may have a channel region in the gate structure 133.

The precharge transistors PRE may include a channel structure 142 and a gate structure 143. Similarly to the cell transistors CT, the precharge transistors PRE may have a first impurity region 142a and a second impurity region 142b exposed to the outside of the gate structure 143, and may have a channel region in the gate structure 143.

On the fourth level LV4, the select transistor SEL and the precharge transistor PRE may be disposed to face each other across one local bit line structure 121. The first impurity region 132a of the select transistor SEL may be in contact with the local bit line 121, and the second impurity region 132b may be electrically connected to the global bit line GBL. The first impurity region 142a of the precharge transistor PRE may be in contact with the local bit line 121, and the second impurity region 142b may be electrically connected to the precharge line VBL.

Conductive patterns 151 to 154 may be disposed in the insulating layer 110, on the upper portion of the memory cell structure 120. The conductive patterns 151 to 154 may be disposed above the first to fourth levels LV1 to LV4 in the third direction (Z-direction), that is, in a position further away from the first to fourth levels LV1 to LV4 on the substrate 101 (e.g. further away from the substrate 101 than the first to fourth levels LV1 to LV4).

The conductive patterns 151 to 154 may include contact patterns 151, first interconnection patterns 152, via patterns 153, and second interconnection patterns 154. At least portions of the first interconnection patterns 152 may provide a precharge line VBL, and at least portions of the second interconnection patterns 154 may provide a global bit line GBL. The precharge line VBL may be electrically connected to a precharge power source.

The select transistor SEL may be electrically connected to the global bit line GBL through the contact pattern 151, the first interconnection pattern 152, and the via pattern 153. Additionally, the precharge transistor PRE may be electrically connected to the precharge line VBL through the contact pattern 151.

According to an example embodiment of the present disclosure, the select transistors SEL and the precharge transistors PRE may have the same structure as that of the cell transistors CT. However, unlike the fact that one end of the cell transistors CT is connected to the cell capacitor 124, one end of the select transistors SEL may be connected to the global bit line GBL, and one end of the precharge transistor PRE may be connected to the precharge line VBL.

According to an example embodiment of the present disclosure, the select transistors SEL and the precharge transistors PRE may be formed in the same semiconductor process as the cell transistors CT, and may function as the select transistors SEL and the precharge transistors PRE depending on the connection structure of the conductive patterns 151 to 154. Accordingly, the number of semiconductor processes for forming the select transistors SEL and the precharge transistors PRE may be reduced.

In an example embodiment described with reference to FIGS. 6 and 7, the select transistors SEL may be connected to the dummy cell capacitors 134 in addition to the global bit line GBL, and the precharge transistors PRE may be connected to the dummy cell capacitors 144 in addition to the precharge line VBL. However, the dummy cell capacitors 134 and 144 may not store valid data.

Each of the select transistors SEL and the global bit line GBL, and each of the precharge transistor PRE and the precharge line VBL may be connected to each other in various structures.

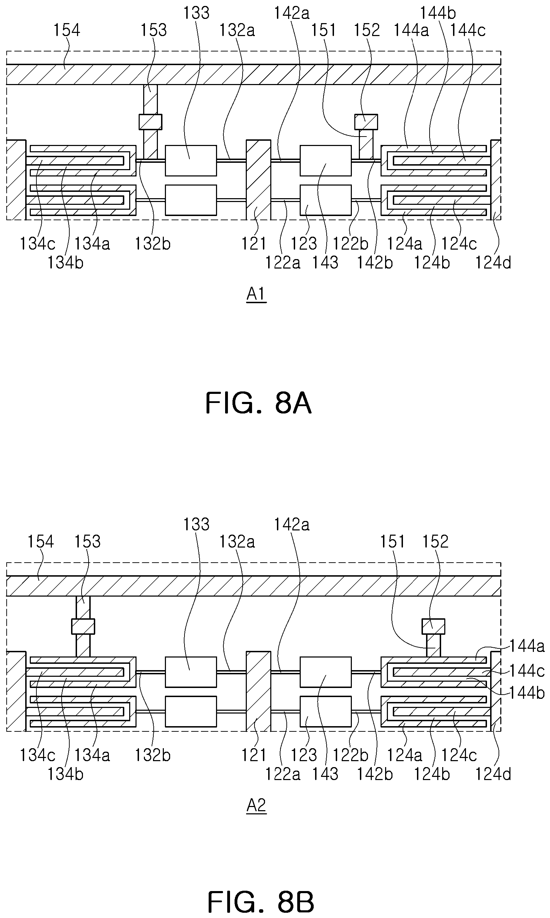

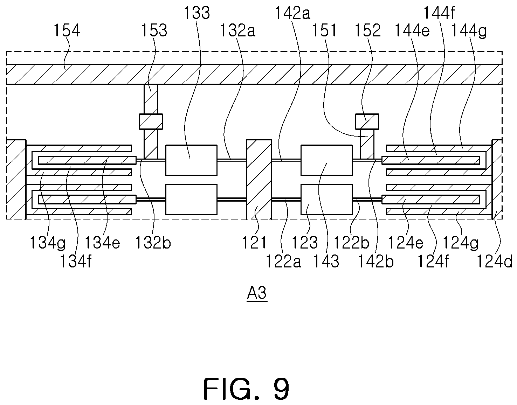

FIGS. 8A, 8B and 9 are enlarged views of region 'A' in FIG. 6 according to example embodiments of the present disclosure.

FIG. 8A and FIG. 8B illustrate specific examples of region 'A' of the memory device 300 described with reference to FIG. 6 and FIG. 7; that is, region 'A1' and region 'A2.' FIG. 8A and FIG. 8B illustrate schematic cross-sections of the cell capacitor 124 and the dummy cell capacitors 134 and 144.

Referring to FIG. 8A and FIG. 8B, the cell capacitor 124 may include a first electrode 124a, a dielectric layer 124b and a second electrode 124c. The first electrode 124a may have a shape surrounding the second electrode 124c. The dielectric layer 124b may be disposed between the first electrode 124a and the second electrode 124c. The first electrode 124a may be in contact with the second impurity region 122b of the cell transistor CT described with reference to FIG. 7. The second electrode 124c may be connected to a power source, for example, a power source having a ground voltage level. That is, the second electrode 124c may be connected to ground or may be connected to a ground line.

The dummy cell capacitors 134 and 144 may have the same structure as that of the cell capacitor 124. The dummy cell capacitor 134 may include a first electrode 134a, a dielectric layer 134b, and a second electrode 134c, and may have a shape in which the first electrode 134a surrounds the second electrode 134c. The dummy cell capacitor 144 may include a first electrode 144a, a dielectric layer 144b, and a second electrode 144c, and may have a shape in which the first electrode 144a surrounds the second electrode 144c.

Meanwhile, the cell transistor 124 may further include a conductive plate 124d. The conductive plate 124d may electrically connect a plurality of second electrodes 124c, 134c and 144c and may be connected to a power source on a ground voltage level.

Referring to FIG. 8A, the select transistor SEL may be electrically connected to the conductive pattern 154 providing the global bit line GBL described with reference to FIG. 7 through a contact pattern 151 in contact with an upper surface of the second impurity region 132b. Additionally, the precharge transistor PRE may be electrically connected to the conductive pattern 152 providing the precharge line VBL described with reference to FIG. 7 through a contact pattern 151 which contacts with an upper surface of the second impurity region 142b.

Referring to FIG. 8B, the select transistor SEL described with reference to FIG. 7 may be electrically connected to the conductive pattern 154 providing the global bit line GBL described with reference to FIG. 7 through a contact pattern 151 in contact with an upper surface of the first electrode 134a. Additionally, the precharge transistor PRE may be electrically connected to the conductive pattern 152 providing the precharge line VBL described with reference to FIG. 7 through a contact pattern 151 in contact with an upper surface of the first electrode 144a.

An arrangement of the contact patterns 151 according to an example embodiment of the present disclosure is not limited to the arrangement illustrated in FIG. 8A and FIG. 8B. For example, the contact patterns 151 may be in contact with both the first electrode 134a and the second impurity region 132b, and/or may be in contact with both the first electrode 144a and the second impurity region 142b.

FIG. 9 illustrates region 'A3', which is a specific example of region 'A' of the memory device 300 described with reference to FIGS. 6 and 7. FIG. 9 specifically illustrates a schematic cross-section of the cell capacitor 124 and the dummy cell capacitors 134 and 144.

Referring to FIG. 9, the cell capacitor 124 may include a first electrode 124e, a dielectric layer 124f, and a second electrode 124g. The first electrode 124e may be in contact with the second impurity region 122b of the cell transistor CT described with reference to FIG. 7, and the second electrode 124g may be electrically connected to the power source on the ground voltage level. Unlike FIG. 8A and FIG. 8B, the second electrode 124g may have a shape surrounding the first electrode 124e, and the dielectric layer 124f may be disposed between the second electrode 124g and the first electrode 124e.

The dummy cell capacitors 134 and 144 may have the same structure as that of the cell capacitor 124. The dummy cell capacitor 134 may include a first electrode 134e, a dielectric layer 134f, and a second electrode 134g, and the second electrode 134g may have a shape in which the first electrode 134e is surrounded by the second electrode 134g. The dummy cell capacitor 144 may include a first electrode 144e, a dielectric layer 144f, and a second electrode 144g, and may have a shape in which the second electrode 144g extends around the first electrode 144e.

Meanwhile, the cell capacitor 124 may further include a conductive plate 124d. The conductive plate 124d may electrically connect a plurality of second electrodes 124g, 134g and 144g and may be connected to the power source on the ground voltage level.

Referring to FIG. 9, the select transistor SEL described with reference to FIG. 7 may be electrically connected to the conductive pattern 154 providing the global bit line GBL described with reference to FIG. 7 through the contact pattern 151 in contact with the upper surface of the second impurity region 132b. Additionally, the precharge transistor PRE described with reference to FIG. 7 may be electrically connected to the conductive pattern 152 providing the precharge line VBL described with reference to FIG. 7 through the contact pattern 151 in contact with the upper surface of the second impurity region 142b.

However, as illustrated in FIG. 9, when the dummy cell capacitors 134 and 144 have second electrodes 134g and 144g connected to the power source of the ground voltage level, the contact pattern 151 may not be in contact with an upper surface of the dummy cell capacitors 134 and 144.

The memory device 300 described with reference to FIGS. 5 to 9 may include a memory cell structure in which cell transistors and cell capacitors are disposed on the four levels LV1 to LV4. However, the number of levels in which the cell transistors and the cell capacitors are disposed is not limited thereto.

Additionally, in FIGS. 5 to 9, an example embodiment of the present disclosure has been described by taking as an example a case in which cell transistors included in one level of the memory cell structure are used as precharge transistors and select transistors. However, the present disclosure is not limited thereto. For example, cell transistors included in a plurality of levels of the memory cell structure may be used as precharge transistors and select transistors.

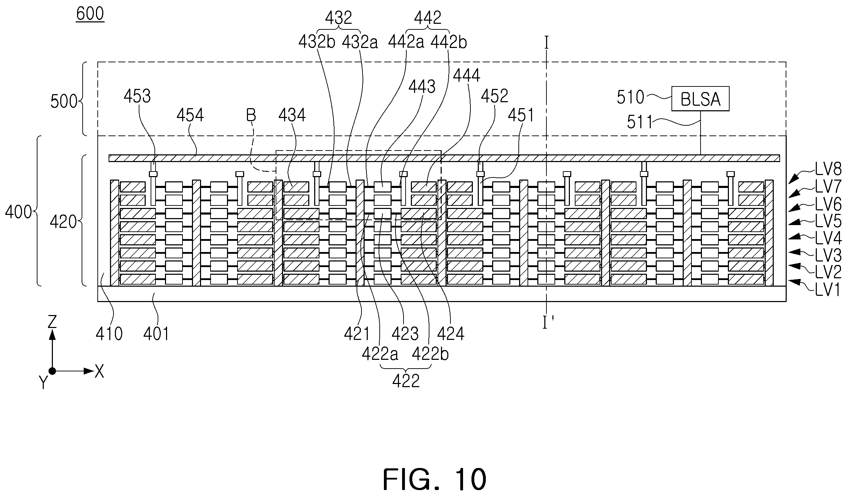

Hereinafter, the structure of a memory device according to an example embodiment of the present disclosure will be described in detail with reference to FIGS. 10 to 12.

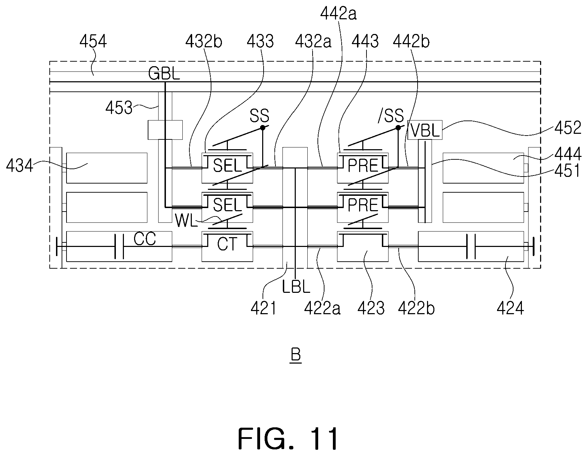

FIG. 10 is a schematic cross-sectional view illustrating the structure of a memory device according to an example embodiment of the present disclosure. FIG. 11 is a circuit diagram of region 'B' of FIG. 10.

Referring to FIGS. 10 and 11 together, a memory device 600 may include a first semiconductor layer 400 and a second semiconductor layer 500. The second semiconductor layer 500 may be stacked in the vertical direction (Z-direction) on an upper portion of the first semiconductor layer 400.

The first semiconductor layer 400 may include a substrate 401, an insulating layer 410 on the substrate 401, a memory cell structure 420 in the insulating layer 410, and conductive patterns 451 to 454. The memory cell structure 420 may include a plurality of local bit lines (LBL) 421, a plurality of cell transistors CT, a plurality of cell capacitors 424, a plurality of select transistors SEL, a plurality of precharge transistors PRE, and dummy cell capacitors 434 and 444.

The second semiconductor layer 500 may include a core control circuit and a peripheral circuit. For example, the second semiconductor layer 500 may include a bit line sense amplifier (BLSA) 510 overlapping the memory cell structure 420 of the first semiconductor layer 400 in a third direction (Z-direction), perpendicular to an upper surface of the substrate 401, and a conductive pattern 511 for electrically connecting the bit line sense amplifier 510 to the conductive pattern 454 of the first semiconductor layer 400.

The memory cell structure 420 may be disposed in the insulating layer 410, on the upper surface of the substrate 401. The memory cell structure 420 may be disposed across a plurality of levels LV1 to LV8 in the third direction (Z-direction). The memory cell structure 420 may move away from the substrate 401 in the order of the first level LV1 to the eighth level LV8, with the first level LV1 being a lowermost one of the plurality of levels LV1 to LV8 closest to the substrate 401.

The local bit lines 421 may extend in the third direction (Z-direction) across the plurality of levels LV1 to LV8. The plurality of cell transistors CT and the plurality of cell capacitors 424 may be disposed in each of the first to sixth levels LV1 to LV6.

The plurality of cell transistors CT may include a channel structure 422 and a gate structure 423. A first impurity region 422a and a second impurity region 422b of the channel structure 422 may be exposed to the outside of the gate structure 423, and the channel region may be disposed in the gate structure 423. The first impurity region 422a may be in contact with the local bit line 421, and the second impurity region 422b may be in contact with the cell capacitor 424. In each of the first to sixth levels LV1 to LV6, a pair of cell transistors CT may be disposed to face each other proximate a common local bit line 421.

According to an example embodiment of the present disclosure, the select transistors SEL and the precharge transistors PRE may be disposed on a plurality of levels selected in an order far from the substrate 401, among the plurality of levels. For instance, the select transistors SEL and the precharge transistors PRE may be disposed on a subset of levels that are furthest from the substrate 101 out of the plurality of levels LV1 to LV8. For example, the select transistors SEL and the precharge transistors PRE may be disposed on each of the seventh and eighth levels LV7 and LV8.

The select transistors SEL may include a channel structure 432 and a gate structure 433. Similarly to the cell transistors CT, the select transistors SEL may have a first impurity region 432a and a second impurity region 432b exposed to the outside of the gate structure 433, and may have a channel region in the gate structure 433.

The precharge transistors PRE may include a channel structure 442 and a gate structure 443. Similarly to the transistors CT, the precharge transistors PRE may have a first impurity region 442a and a second impurity region 442b exposed to the outside of the cell gate structure 443, and may have a channel region inside the gate structure 443.

In each of the seventh and eighth levels LV7 and LV8, a select transistor SEL and a precharge transistor PRE may be disposed to face each other proximate a common local bit line 421. The select transistors SEL disposed on each of the seventh and eighth levels LV7 and LV8 may overlap each other in the third direction (Z-direction), and may be electrically connected to each other in parallel. Similarly, the precharge transistors PRE disposed on each of the seventh and eighth levels LV7 and LV8 overlap each other in the third direction (Z-direction), and may be electrically connected to each other in parallel.

Specifically, the first impurity region 432a of each of the select transistors SEL may be in contact with the local bit line 421, and the second impurity region 432b of each of the select transistor SEL may be electrically connected to the global bit line GBL. Additionally, the gate structures 433 of each of the select transistors SEL may be connected to the same control signal SS.

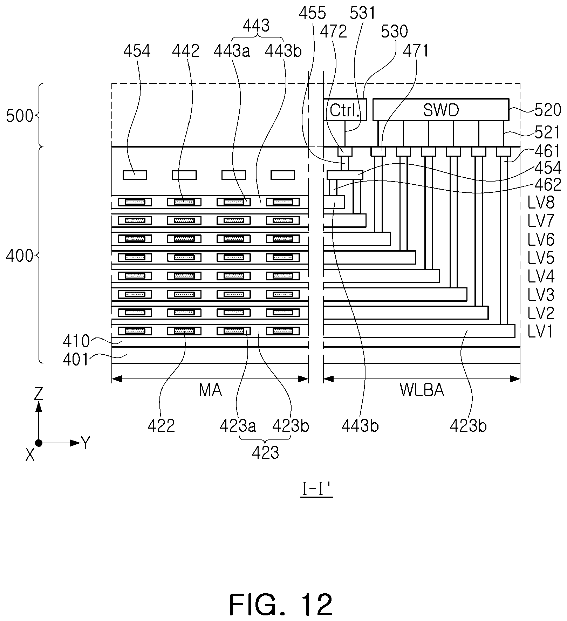

Additionally, the first impurity region 442a of each of the precharge transistors PRE may be in contact with the local bit line 421, and the second impurity region 442b of each of the precharge transistors PRE may be electrically connected to the precharge line VBL. Additionally, the gate structures 443 of each of the precharge transistors PRE may be connected to the same control signal /SS. The connection between the gate structures 433 and 443 and the control signals will be described below with reference to FIG. 12.

In an upper side of the memory cell structure 420, conductive patterns 451 to 454 may be disposed in the insulating layer 410. Similarly to the memory device 300 described with reference to FIGS. 6 and 7, at least portions of first interconnection patterns 452 may provide a precharge line VBL, and at least portions of second interconnection patterns 454 may provide a global bit line GBL.

Additionally, the select transistors SEL may be electrically connected to the global bit line GBL through the contact pattern 451, the first interconnection pattern 452 and the via pattern 453, and the precharge transistors PRE may be electrically connected to the precharge line VBL through the contact pattern 451.

In an example embodiment, the select transistors SEL overlapping each other in the third direction (Z-direction) may be in contact with one contact pattern 451 extending in the third direction (Z-direction). Additionally, the precharge transistors PRE overlapping each other in the third direction (Z-direction) may be in contact with one contact pattern 451 extending in the third direction (Z-direction).

According to an example embodiment of the present disclosure, the memory device may be formed of select transistors in which cell transistors included in a plurality of levels are connected in parallel, and may control the select transistors simultaneously using one control signal. Similarly, the memory device may be formed of precharge transistors in which the cell transistors included in the plurality of levels are connected in parallel, and may control the precharge transistors simultaneously using one control signal.

The memory device may improve the driving capability of the precharge transistor and the select transistor by simultaneously controlling the cell transistors included in the plurality of levels. For example, with an increase in the number of cell transistors connected in parallel across the plurality of levels, the driving current of the precharge transistor and the select transistor may increase. Additionally, with an increase in the number of cell transistors connected in parallel across the plurality of levels, the channel resistance of the select transistor may decrease, so that the load resistance of the global bit line may decrease.

Hereinafter, with reference to FIG. 12, the connection between the gate structures 433 and 443 and the control signals will be described.

FIG. 12 is a schematic cross-sectional view taken along line I-I' of FIG. 10.

Referring to FIG. 12, the memory device 600 may include a main area MA and a word line bonding area WLBA spaced apart from the main area MA in the second direction (Y-direction).

The main area MA may include a plurality of memory cells MC, a plurality of select transistors SEL, and a plurality of precharge transistors PRE, described with reference to FIGS. 10 and 11. In the main area MA, the gate structures 423 and 443 may include gate insulating layers 423a and 443a surrounding the plurality of channel structures 422 and 442, and gate electrodes 423b and 443b surrounding the gate insulating layers 423a and 443a and extending in the second direction (Y-direction).

In the example of FIG. 12, the gate structures 423 of the first to sixth levels LV1 to LV6 may be included in the cell transistors CT, and the gate structures 443 of the seventh and eighth levels LV7 and LV8 may be included in the precharge transistors PRE.

The word line bonding area WLBA may be adjacent to the main area MA in the second direction (Y-direction). The gate electrodes 423b of the main area MA may extend to the word line bonding area WLBA and may provide word lines. The gate electrodes 443b of the main area MA may extend to the word line bonding area WLBA, and may provide control signal lines.

The memory cell structure 420 may have a staircase shape in the word line bonding area WLBA in the Y-Z plane. Specifically, the gate electrodes 423b of the first to eighth levels LV1 to LV8 may extend to different lengths in the second direction (Y-direction). For example, the gate electrode 423b of the first level LV1 closest to the substrate 401 may have the longest length extending in the second direction (Y-direction), and the gate electrode 423b farther from the substrate 401 in the third direction (Z-direction) may have a shorter length extending in the second direction (Y-direction). The length of the gate electrodes in the second direction (Y-direction) may decrease with increasing distance from the substrate 101.

The gate electrodes 423b and 443b may include upper surfaces that do not overlap other gate electrodes in the third direction (Z-direction) in the third direction (Z-direction). For instance, the gate electrodes 423b and 443b may include upper surfaces that do not overlap in the third direction (Z-direction) any gate electrodes located above the respective gate electrodes 423b and 443b. The gate electrodes 423b may be electrically connected to a sub-word line driver (SWD) 520 of the second semiconductor layer 500 through contact plugs 461 in contact with the upper surfaces of the gate electrodes 423b and extending in the third direction (Z-direction), and first pads 471 in contact with upper surfaces of the contact plugs 461. A conductive pattern 521 (e.g. one or more conductive lines) electrically connecting the sub-word line driver 520 to the first pads 471 in the second semiconductor layer 500 is schematically illustrated.

The sub-word line driver 520 may drive the word line by applying a word line voltage to the gate electrodes 423b.

Upper surfaces of each of the gate electrodes 443b may be in contact with contact plugs 462 extending in the third direction (Z-direction). The contact plugs 462 may be electrically connected to a control circuit 530 through a second pad 472. A conductive pattern 531 (e.g. one or more conductive lines) electrically connecting the control circuit 530 to the second pad 472 in the second semiconductor layer 500 is schematically illustrated.

The control circuit 530 may turn on or off the precharge transistors PRE (see FIGS. 10 and 11) by applying a complementary select signal to the gate electrodes 443b.

The complementary select signals having the same logic state may be simultaneously applied to the gate electrodes 443b overlapping each other in the third direction (Z-direction). In an example embodiment, the contact plugs 462 may be electrically connected to the control circuit 530 through one second pad 472. Interconnection patterns 454 and 455 may be formed to distribute the complementary select signals transmitted from the second pad 472 to the contact plugs 462.

Each of the plurality of second interconnection patterns 454 is electrically connected to a corresponding one of the plurality of local bit line structures 421 in response to a control signal from the control circuit 530.

According to an example embodiment of the present disclosure, the memory device 600 (see FIGS. 10 and 11) may include select transistors SEL and precharge transistors PRE overlapping the cell transistors CT in the first semiconductor layer 400 in the third direction (Z-direction). The select transistors SEL and the precharge transistors PRE may also overlap the bit line sense amplifier 510 of the second semiconductor layer 500 in the third direction (Z-direction) (see FIGS. 10 and 11).

Additionally, the memory device 600 may include select transistors SEL electrically connected in parallel across the plurality of levels and precharge transistors PRE connected in parallel. The select transistors SEL electrically connected in parallel and the precharge transistors PRE electrically connected in parallel may have high driving capability without increasing an area of the memory device 600.

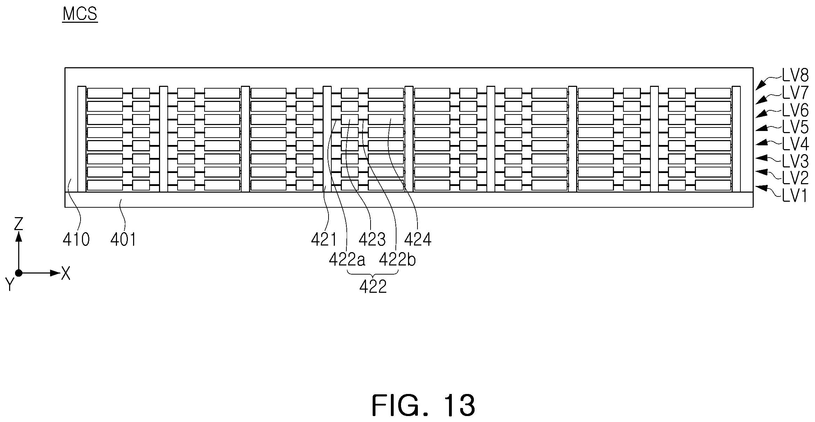

FIGS. 13 to 15 are schematic views illustrating intermediate processes in a manufacturing process of a first semiconductor layer included in a memory device according to an example embodiment of the present disclosure.

Referring to FIG. 13, a memory cell structure MCS may be prepared to manufacture a first semiconductor layer 400 (see FIG. 12). The memory cell structure MCS may correspond to the memory cell structure MCS described with reference to FIG. 3. However, the memory cell structure MCS of FIG. 13 may include memory cells formed across eight levels LV1 to LV8, unlike the memory cell structure MCS described with reference to FIG. 3.

The memory cell structure MCS may include bit line structures 421, channel structures 422, gate structures 423, and cell capacitors 424 formed in each of the first to eighth levels LV1 to LV8 in the insulating layer 410 on an upper portion of the substrate 401.

The first to eighth levels LV1 to LV8 of the memory cell structure MCS may be formed integrally through a plurality of semiconductor processes. For example, an insulating layer and a semiconductor material layer may be sequentially deposited on each of the first to eighth levels LV1 to LV8, on the upper surface of the substrate 401. The insulating layer may include silicon oxide, although embodiments are not limited thereto.

The semiconductor material layer may include a single crystal semiconductor material. The single crystal semiconductor material may include a group IV semiconductor, a group III-V compound semiconductor, or a group II-VI compound semiconductor, and may be, for example, a single crystal semiconductor including at least one of silicon, silicon carbide, germanium, or silicon-germanium. However, the present disclosure is not limited thereto, and the semiconductor material layer may include at least one of a polycrystalline semiconductor material layer, an oxide semiconductor material layer such as Indium Gallium Zinc Oxide (IGZO), or a two-dimensional material layer such as MoS2 (Molybdenum disulfide).

The semiconductor material layer deposited on each of the first to eighth levels LV1 to LV8 may be formed of a P-type material. Additionally, positions corresponding to the first impurity region 422a and the second impurity region 422b may be doped with N-type impurities.

The gate structures 423 may be formed by etching a periphery of the channel structure 422 and depositing materials of the gate insulating layer 423a and a gate electrode 423b (see FIG. 12) around the channel structure 422. The periphery of the channel structure 422 may be etched vertically and laterally so that the gate structures 423 may be formed to have a shape surrounding (i.e., extending around) the channel structures 422. The bit line structures 421 and the cell capacitors 424 may be formed by etching the periphery of the first impurity region 422a and the second impurity region 422b and depositing a conductive material.

The insulating layer 410 covering the upper surface of the substrate 401, the bit line structures 421, the channel structures 422, the gate structures 423, and the cell capacitors 424 may be formed to complete memory cell structure MCS. The term "covering" (or "covers," or like terms), as may be used herein, is intended to broadly refer to an element, structure or layer that is on or over another element, structure or layer, either directly or with one or more other intervening elements, structures or layers therebetween.

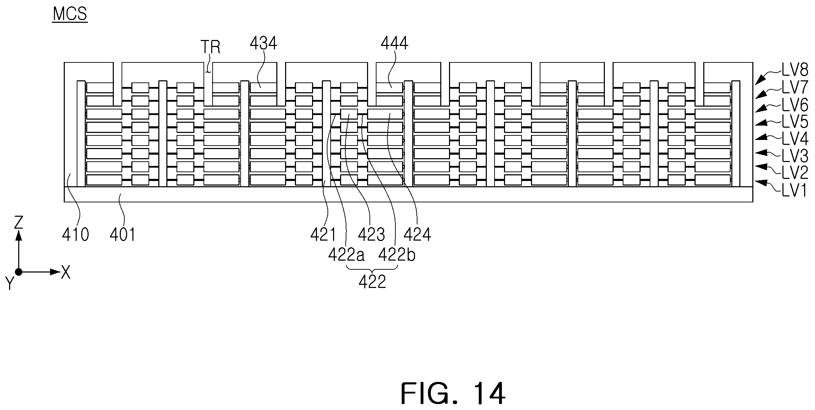

Referring to FIG. 14, a trench TR may be formed in the memory cell structure MCS by etching the memory cell structure MCS in the third direction (Z-direction). In the example of FIG. 14, the trench TR may be formed to penetrate through (i.e., extend in) the seventh and eighth levels LV7 and LV8 from an upper surface of the insulating layer 410 in a predetermined area. In one or more embodiments, the trench TR may not penetrate the first to sixth levels LV1 to LV6. The trench TR may be formed to remove at least a portion of the cell capacitors 424, and the second impurity regions 422b of the seventh and eighth levels LV7 and LV8 may be exposed to the outside. At least portions of the removed cell capacitors may be dummy cell capacitors 434 and 444 electrically separated from the cell transistors.

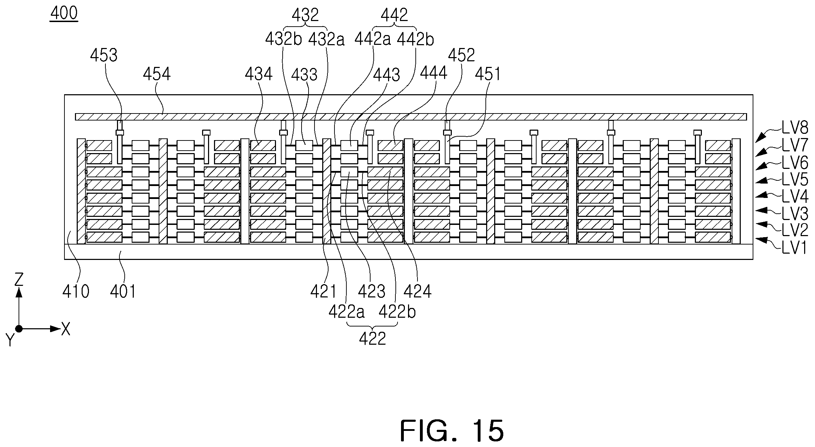

Referring to FIG. 15, contact patterns 451 in contact with the second impurity regions 422b of the seventh and eighth levels LV7 and LV8 through the trench TR may be formed, and conductive patterns 452 to 454 may be formed on upper portions of the contact patterns 451.

Each of the cell transistors of the seventh and eighth levels LV7 and LV8 may be a select transistor electrically connected to the global bit line GBL or a precharge transistor electrically connected to the precharge line VBL, depending on the connection structure with the conductive patterns 452 to 454. FIG. 15 illustrates the first and second impurity regions 432a and 432b and the gate structure 433 of the channel structure which are included in the select transistor. Additionally, in FIG. 15, the first and second impurity regions 442a and 442b and the gate structure 443 of the channel structure which are included in the precharge transistor are illustrated.

According to an example embodiment of the present disclosure, the select transistors and the precharge transistors may be formed integrally with the cell transistors, and may be formed by forming the conductive patterns 451 to 454 in the memory cell structure. Accordingly, the semiconductor process for manufacturing the select transistors and the precharge transistors having improved driving capability may be simplified without increasing an area of the memory device 600.

Hereinafter, circuit configurations that may be applied to the memory device described with reference to FIGS. 1 to 15 will be described.

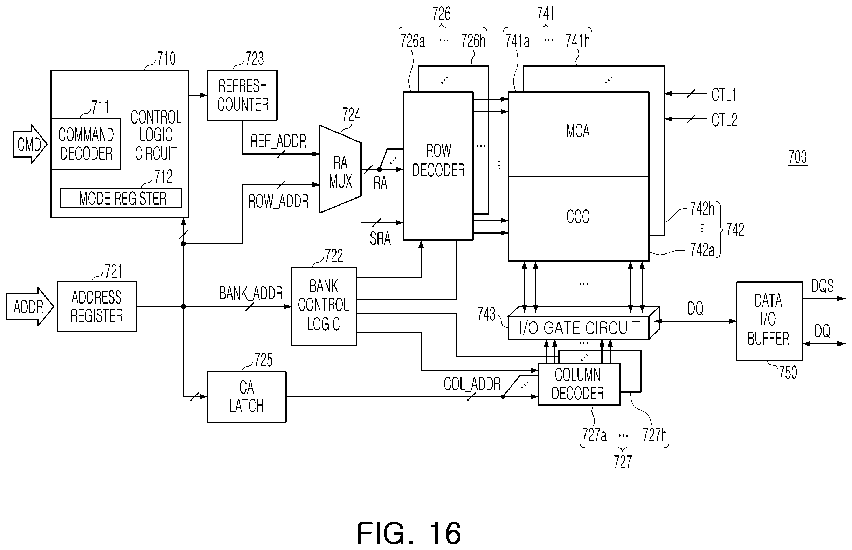

FIG. 16 is a schematic block diagram illustrating a memory device according to an example embodiment of the present disclosure.

Referring to FIG. 16, a memory device 700 may include a control logic circuit 710, an address register 721, a bank control circuit 722, a refresh counter 723, a row address multiplexer 724, a column address latch 725, a row decoder 726, a column decoder 727, a memory core circuit 741, a sense amplifier 742, an input/output gate circuit 743, and a data input/output buffer 750.

The memory device 700 may include a first semiconductor layer and a second semiconductor layer disposed in a vertical direction, perpendicular to the substrate (e.g., see FIG. 2). The memory core circuit 741 may be formed in a cell region of the first semiconductor layer and a core circuit region of the second semiconductor layer. The address register 721, the bank control circuit 722, the refresh counter 723, the row address multiplexer 724, the column address latch 725, the row decoder 726, the column decoder 727, the sense amplifier 742, the input/output gate circuit 743, and the data input/output buffer 750 may be included in a peripheral circuit region of the second semiconductor layer.

The memory core circuit 741 may include a plurality of memory core circuits 741a to 741h. Additionally, a plurality of row decoders 726 (726a to 726h), a plurality of column decoders 727 (727a to 727h), and a plurality of sense amplifiers 742 (742a to 742h) may be connected to the plurality of memory core circuits 741a to 741h, respectively.

The plurality of memory core circuits 741a to 741h, the plurality of sense amplifiers 742a to 742h, the plurality of column decoders 727a to 727h and the plurality of row decoders 726a to 726h may be respectively included in a plurality of banks.

Each of the plurality of memory core circuits 741a to 741h may include a memory cell array MCA and a core control circuit CCC. The memory cell array MCA may be disposed in the first semiconductor layer, and the core control circuit CCC may overlap the memory cell array MCA in a direction, parallel to the upper surface of the substrate, in a second semiconductor layer.

The memory cell array MCA may include a plurality of word lines, a plurality of bit lines, and a plurality of memory cells connected to the plurality of word lines and the plurality of bit lines.

According to an example embodiment of the present disclosure, the plurality of bit lines may be hierarchized into local bit lines and global bit lines, as previously described, for example, in connection with FIGS. 1 to 15. The memory cell array MCA may include one or more memory cell structures having a plurality of cell capacitors and a plurality of cell transistors disposed on each of the plurality of levels defined in the vertical direction, perpendicular to the substrate.

The cell transistors disposed in one or more of the plurality of levels may be used as select transistors and precharge transistors. One select transistor and one precharge transistor may be electrically connected to one local bit line. For example, a first impurity region of the select transistor may be connected to the local bit line, and a second impurity region may be connected to the global bit line. Additionally, a first impurity region of the precharge transistor may be connected to the local bit line, and a second impurity region may be connected to a precharge line.

The core control circuit CCC may include circuits for controlling the memory cell array MCA. For example, the core control circuit CCC may include a sub-word line driver circuit for driving the plurality of word lines, and a bit line sense amplifier circuit for sensing voltage changes of the plurality of bit lines and amplifying the voltage changes.

According to an example embodiment of the present disclosure, the core control circuit CCC may overlap the memory cell array MCA in the vertical direction, perpendicular to the substrate. For example, the bit line sense amplifier circuit may be connected to the global bit line in an upper portion of the memory cell structure, and may be selectively connected to one local bit line depending on whether the select transistors connected to the global bit line are turned on.

The address register 721 may receive an address ADDR including a bank address BANK_ADDR, a row address ROW_ADDR, and a column address COL_ADDR from a memory controller connected to the memory device 700. The address register 721 may provide the received bank address BANK_ADDR to the bank control logic 722, may provide the received row address ROW_ADDR to the row address multiplexer 724, and may provide the received column address COL_ADDR to the column address latch 725.

The bank control logic 722 may generate bank control signals in response to the bank address BANK_ADDR. In response to the bank control signals, a row decoder corresponding to the bank address BANK_ADDR, among the plurality of row decoders 724a to 724h, may be activated, and a column decoder corresponding to the bank address BANK_ADDR, among the plurality of column decoders 727a to 727h, may be activated.

The row address multiplexer 724 may receive the row address ROW_ADDR from the address register 721, and may receive a refresh row address REF_ADDR from the refresh counter 723. The row address multiplexer 724 may selectively output the row address ROW_ADDR or the refresh row address REF_ADDR as a row address RA. The row address RA output from the row address multiplexer 724 may be applied to each of the plurality of row decoders 726a to 726h.

The refresh counter 723 may sequentially increase or decrease the refresh row address REF_ADDR according to the control of the control logic circuit 710.

A row decoder activated by the bank control logic 722, among the plurality of row decoders 726a to 726h, may decode the row address RA output from the row address multiplexer 724 and may activate the word line corresponding to the row address. For example, the activated row decoder may apply a word line driving voltage to the word line corresponding to the row address.

The column address latch 725 may receive a column address COL_ADDR from the address register 721 and may at least temporarily store the received column address COL_ADDR. Additionally, the column address latch 725 may incrementally increase the received column address COL_ADDR, in a burst mode. The column address latch 725 may apply the temporarily stored or incrementally increased column address COL_ADDR to each of the plurality of column decoders 727a to 727h.

The column decoder activated by the bank control logic 722, among the plurality of column decoders 727a to 727h, may activate a sense amplifier corresponding to the bank address BANK _ADDR and the column address COL_ADDR through a corresponding input/output gating circuit 743.

The input/output gating circuit 743 may include input data mask logics, read data latches for storing data output from the plurality of memory core circuits 741a to 741h, and write drivers for writing data to the plurality of memory core circuits 741a to 741h, along with circuits for gating input/output data.

A data signal DQ to be read from one of the bank arrays of the plurality of memory core circuits 741a to 741h may be sensed by a sense amplifier corresponding to the one bank array, and may be stored in the read data latches. The data signal DQ stored in the read data latches may be provided to a memory controller (not explicitly shown) along with a data strobe signal DQS.

The data signal DQ to be written to a memory cell array MCA included in one of the plurality of memory core circuits 741a to 741h may be provided to the input/output gating circuit 743 by the data input/output buffer 750. The input/output gating circuit 743 may write the data signal DQ to a target page of the one memory cell array MCA through the write drivers.

The data input/output buffer 750 may provide the data signal DQ to the input/output gating circuit 743 in a write operation, and may provide the data signal DQ provided from the input/output gating circuit 743 to the memory controller in a read operation.

The control logic circuit 710 may control an operation of the memory device 700. For example, the control logic circuit 710 may generate control signals so that the memory device performs a write operation or a read operation. The control logic circuit 710 may include a command decoder 711 configured for decoding a command CMD, received from the memory controller, and a mode register 712 configured for setting an operation mode of the memory device 700.

For example, the command decoder 711 may decode a write enable signal, a row address strobe signal, a column address strobe signal, a chip select signal, and the like, thus generating the control signals corresponding to the command CMD.

According to an example embodiment of the present disclosure, the memory device may include select transistors configured to reduce loading capacitance of a global bit line and precharge transistors that may effectively precharge local bit lines. Since positions of the select transistors and the precharge transistors may overlap positions of the cell transistors, the area of the memory device may be reduced. Additionally, since the select transistors and the precharge transistors may be formed integrally with the cell transistors, the semiconductor process for forming the memory device may be simplified.

Embodiments are set out in the following clauses:
Clause 1. A memory device, comprising:
   a plurality of local bit line structures arranged in a first direction and a second direction parallel to a surface of a substrate of the memory device and intersecting each other, and respectively extending in a vertical direction across a plurality of first levels and one or more second levels in a vertical direction, perpendicular to the surface of the substrate;
   a plurality of first channel structures and a plurality of second channel structures, each of the plurality of first and second channel structures extending in the first direction on respective ones of the plurality of first levels and the one or more second levels, each of the plurality of first and second channel structures is adjacent to sidewalls of respective ones of the plurality of local bit line structures and has a first impurity region and a second impurity region opposite the first impurity region, the first impurity regions of adjacent channel structures of the plurality of first and second channel structures facing each other;
   a plurality of gate structures extending in the second direction on respective ones of the plurality of first levels and the one or more second levels, each of the plurality of gate structures is in contact with channel structures arranged in the second direction, among the plurality of first channel structures and the plurality of second channel structures;
   a plurality of cell capacitors adjacent to the second impurity regions of each of the plurality of first channel structures and the plurality of second channel structures on each of the plurality of first levels;
   a plurality of first interconnection patterns extending in the first direction and arranged in the second direction, and electrically connected to the second impurity regions of channel structures arranged in the first direction, among the plurality of first channel structures on the one or more second levels; and
   a plurality of second interconnection patterns extending in the second direction and arranged in the first direction, and electrically connected to the second impurity regions of channel structures arranged in the second direction, among the plurality of second channel structures on the one or more second levels.
Clause 2. The memory device of Clause 1, further comprising:
   a plurality of bit line sense amplifiers;
   a plurality of first conductive patterns electrically connecting the plurality of bit line sense amplifiers to the plurality of first interconnection patterns;
   a precharge power source; and
   a plurality of second conductive patterns electrically connecting the precharge power source to the plurality of second interconnection patterns.
Clause 3. The memory device of Clause 1 or Clause 2, further comprising:
   a plurality of dummy cell structures separated from the plurality of first channel structures and the plurality of second channel structures on the one or more second levels.
Clause 4. A memory device, comprising:
   a first semiconductor layer; and
   a second semiconductor layer stacked on the first semiconductor layer,
   wherein the first semiconductor layer includes:
      a memory cell structure including a plurality of local bit line structures in a first direction, parallel to a surface of a substrate of the memory device and a second direction parallel to the surface of the substrate and intersecting the first direction, and extending in a vertical direction, perpendicular to the surface of the substrate, first cell transistors and second cell transistors respectively including a first impurity region in a plurality of positions in the vertical direction and connected to corresponding ones of the plurality of local bit line structures and a second impurity region opposite the first impurity region, and a plurality of cell capacitors connected to the second impurity regions of cell transistors in a plurality of first positions of the plurality of positions, among the first cell transistors and the second cell transistors;
      a plurality of first interconnection patterns electrically connected to the second impurity regions of the first cell transistors in one or more second positions, among the plurality of positions; and
      a plurality of second interconnection patterns electrically connected to the second impurity regions of the second cell transistors in the one or more second positions,
      wherein the second semiconductor layer includes:
         a plurality of bit line sense amplifiers electrically connected to respective ones of the plurality of first interconnection patterns; and
         a precharge power source electrically connected to respective ones of the plurality of second interconnection patterns.
Clause 5. The memory device of Clause 4, wherein the memory cell structure further includes a plurality of gate structures included in respective cell transistors arranged in the second direction, among the first cell transistors and the second cell transistors.
Clause 6. The memory device of Clause 5, wherein the second semiconductor layer further includes a plurality of sub-word line drivers electrically connected to first gate structures in the plurality of first positions, among the plurality of gate structures.
Clause 7. The memory device of any of Clauses 4-6, wherein the second semiconductor layer further includes:
   a control circuit electrically connected to second gate structures in the one or more second positions, among the plurality of gate structures, and
   wherein each of the plurality of local bit line structures is selectively electrically connected to a corresponding one of the plurality of bit line sense amplifiers or the power source in response to a first control signal from the control circuit.
Clause 8. The memory device of Clause 7, wherein each of the plurality of first interconnection patterns is electrically connected to a corresponding one of the plurality of local bit line structures in response to a second control signal from the control circuit.
Clause 9. The memory device of any of Clauses 4-8, wherein the plurality of bit line sense amplifiers overlap the memory cell structure in the vertical direction.

The present disclosure is not limited to the above-described embodiments and the accompanying drawings but is defined by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure.

## Claims

1. A memory device, comprising:
a substrate;
a plurality of local bit line structures arranged in a first direction and a second direction parallel to an upper surface of the substrate and intersecting each other, and extending across a plurality of levels in a vertical direction, perpendicular to the upper surface of the substrate;
a plurality of first channel structures and a plurality of second channel structures, each of the first and second channel structures extending in the first direction on a respective one of the plurality of levels, and respectively contacting sidewalls of each of the plurality of local bit line structures, each of the first and second channel structures having a first impurity region and a second impurity region opposite the first impurity region, first impurity regions of adjacent channel structures of the plurality of first and second channel structures facing one another;
a plurality of gate structures extending in the second direction on each of the plurality of levels, and respectively contacting channel structures arranged in the second direction, among the plurality of first channel structures and the plurality of second channel structures;
a plurality of cell capacitors in contact with the second impurity regions of each of the plurality of first channel structures and the plurality of second channel structures;
a plurality of first interconnection patterns extending in the first direction and arranged in the second direction, and respectively electrically connected to the second impurity regions of first channel structures arranged in the first direction, among the plurality of first channel structures on one or more first levels of the plurality of levels; and
a plurality of second interconnection patterns extending in the second direction and arranged in the first direction, and respectively electrically connected to the second impurity regions of second channel structures arranged in the second direction, among the plurality of second channel structures on the one or more first levels.

2. The memory device of claim 1, further comprising:
a plurality of bit line sense amplifiers; and
a plurality of first conductive patterns electrically connecting the plurality of bit line sense amplifiers to the plurality of first interconnection patterns;
a precharge power source; and
a plurality of second conductive patterns electrically connecting the precharge power source to the plurality of second interconnection patterns.

3. The memory device of claim 1 or claim 2, wherein the one or more first levels are at a distance farthest from the substrate in the vertical direction, among the plurality of levels.

4. The memory device of any preceding claim, wherein the one or more first levels include two or more levels selected in an order farthest from the substrate in the vertical direction, among the plurality of levels.

5. The memory device of any preceding claim, wherein each of the plurality of cell capacitors includes:
a first electrode in contact with the second impurity region of a corresponding one of the plurality of first and second channel structures;
a second electrode connected to a power source; and
a dielectric layer between the first electrode and the second electrode.

6. The memory device of claim 5, wherein the second electrode extends around at least a portion of the dielectric layer and at least a portion of the first electrode.

7. The memory device of claim 5, wherein the first electrode extends around at least a portion of the dielectric layer and at least a portion of the second electrode, and
wherein the memory device further includes:
first contact patterns respectively extending in the vertical direction, and contacting the first interconnection patterns and the first electrodes of cell capacitors connected to the first channel structure in the one or more first levels, among the plurality of cell capacitors; and
second contact patterns respectively extending in the vertical direction, and contacting the second interconnection patterns and the first electrodes of cell capacitors connected to the second channel structure in the one or more first levels, among the plurality of cell capacitors.

8. The memory device of any of claims 1-6, further comprising:
first contact patterns respectively extending in the vertical direction, and contacting the first interconnection patterns and the second impurity regions of the first channel structures in the one or more first levels, and
second contact patterns respectively extending in the vertical direction, and contacting the second interconnection patterns and the second impurity regions of the second channel structures in the one or more first levels.

9. The memory device of any preceding claim, wherein the plurality of gate structures have different lengths in the second direction, and
wherein the memory device includes:
a plurality of sub-word line drivers;
a control circuit;
a plurality of first contact plugs in contact with first gate structures on the one or more first levels, among the plurality of gate structures;
a plurality of second contact plugs contacting second gate structures on a plurality of second levels excluding the one or more first levels among the plurality of levels, among the plurality of gate structures, the plurality of second levels being closer to the substrate in the vertical direction relative to the one or more first levels;
a plurality of first conductive patterns electrically connecting the plurality of first contact plugs to the control circuit; and
a plurality of second conductive patterns electrically connecting the plurality of second contact plugs to the plurality of sub-word line drivers.

10. The memory device of any preceding claim, wherein each of the first channel structures and the second channel structures includes a channel region between the first impurity region and the second impurity region, and
wherein each of the plurality of gate structures includes a gate insulating layer extending around the channel region and a gate electrode extending around the gate insulating layer and extending in the second direction.

11. The memory device of any preceding claim, wherein each of the first channel structures and the second channel structures includes a semiconductor material, and
the first impurity regions and the second impurity regions include N-type impurities.

12. The memory device of claim 1 to 11, further comprising:
a first semiconductor layer including the substrate, the plurality of local bit line structures, the plurality of first channel structures, the plurality of second channel structures, the plurality of gate structures, the plurality of cell transistors, and the plurality of first interconnection patterns, and the plurality of second interconnection patterns; and
a second semiconductor layer stacked on the first semiconductor layer,
wherein the second semiconductor layer includes:
a plurality of bit line sense amplifiers electrically connected to respective ones of the plurality of first interconnection patterns; and
a precharge power source electrically connected to respective ones of the plurality of second interconnection patterns.

13. The memory device of claim 12, wherein the second semiconductor layer further includes a plurality of sub-word line drivers electrically connected to first gate structures in a plurality of first positions, among the plurality of gate structures.

14. The memory device of claim 12 or claim 13, wherein the second semiconductor layer further includes:
a control circuit electrically connected to second gate structures in one or more second positions, among the plurality of gate structures, and
wherein each of the plurality of local bit line structures is selectively electrically connected to a corresponding one of the plurality of bit line sense amplifiers or the precharge power source in response to a first control signal from the control circuit.

15. The memory device of claim 14, wherein each of the plurality of first interconnection patterns is electrically connected to a corresponding one of the plurality of local bit line structures in response to a second control signal from the control circuit.
